# EUROPEAN PATENT APPLICATION

(11) **EP 1 231 636 A2**
(43) Date of publication of application: **14.08.2002**
(21) Application number: 02002265.3
(22) Date of filing: 30.01.2002
(51) Int. Cl.: H01L 23/495, H01L 21/56

(54) **Semiconductor device, production method therefor, and electrophotographic apparatus**

(30) Priority: 31.01.2001 JP 2001023871; 18.01.2002 JP 2002009926
(71) Applicant: CANON KABUSHIKI KAISHA, Ohta-ku, Tokyo (JP)
(72) Inventor: Muta, Tadayoshi, Ohta-ku, Tokyo (JP)
(74) Representative: Leson, Thomas Johannes Alois, Dipl.-Ing.

(57) **Abstract**

The semiconductor device of the present invention comprises an IC chip, and a coil connected to the IC chip, in which information is transmitted by using as a transmission medium an induction field generated from the coil, characterized in that the coil, and connecting terminals connected to the coil and electrically connected to the IC chip are formed of the same metal plate that is patterned.

## Description

### BACKGROUND OF THE INVENTION

### Field of the Invention

The present invention relates to a semiconductor apparatus, which has at least an IC chip, and a coil connected to the IC chip and performs information transmission by using an induction field as a transmission medium, a production method therefor, and an electrophotographic apparatus having the semiconductor device mounted thereon.

### Related Background Art

Recently, from the viewpoint of the efficiency improvement and security of information processing, non-contacting type semiconductor devices such as non-contact type IC tags and non-contact type IC cards are spreading, the non-contacting type semiconductor devices each incorporating a coil for an antenna, which transmits and receives data via an electromagnetic wave, and an IC chip in which a semiconductor element performing the recording and processing of data is mounted.

Up to now, this non-contact type semiconductor device comprises a coil for an antenna for transmitting and receiving a data signal and electric power between the coil and a reader-writer which performs reading and writing of data, electronic parts such as an IC chip for processing the above-described signal, and a substrate which connects and supports the coil for an antenna, and the electronic parts.

Japanese Patent Application Laid-Open No. 11-144018 discloses a non-contact type IC card formed by forming a hot melt layer on a substrate, forming a coil for an antenna by making a wire such as a copper wire, supplied from a pulley, wound around the hot melt layer and embedded, connecting the coil for an antenna with an IC chip arranged near the center of the hot melt layer, and further covering them with an over film.

Japanese Patent Application Laid-Open No. 10-337982 discloses a non-contact type IC card formed by forming on a substrate a coil-shaped copper foil etching pattern which serves as an antenna by etching, and simultaneously forming a die pad for mounting an IC chip, and then connecting the IC chip, which is mounted on the die pad, to the copper foil etching pattern by wire bonding, and further bonding and fixing the substrate with an electroconductive adhesive.

Japanese Patent Application Laid-Open No. 11-250214 discloses a non-contact type IC card formed by forming a coil for an antenna by printing conductive paste in a coiled shape on a substrate, connecting an IC chip to the coil for an antenna by jumpers after mounting the IC chip on the substrate, fixing the IC chip by hardening the conductive paste, and performing hot stamping after laminating a film material over the substrate.

However, as shown in the above-described conventional technology, a substrate is indispensable in order to arrange a coil for an antenna in formation of a semiconductor device such as an IC card. Therefore, since material cost relating to the substrate is irreducible, this becomes one of factors that disturb the cost reduction of an IC card. In addition, this is also a factor that disturbs weight reduction that is an important specification required of an IC card.

In addition, in the coil for an antenna that is formed by a wire and is mentioned in Japanese Patent Application Laid-Open No. 11-144018, wiring of the wire is complicated and connection with an IC chip is also complicated. Therefore, it is quite difficult to reduce its production cost.

Furthermore, in the coil for an antenna that is formed by etching and is mentioned in Japanese Patent Application Laid-Open No. 10-337982, and in the coil for an antenna that is formed by printing and is mentioned in Japanese Patent Application Laid-Open No. 11-250214, their production processes relating to etching and printing are complicated, which increases their costs. In addition, there is a problem that a material cost relating to it is also expensive.

The present invention has been made in view of the above-described problems, and aims to provide a semiconductor device which has reduced a production cost including a material cost by not only reducing the material cost of an IC card, but also lightening the IC card by omitting a substrate, and simplifying production process therefor, and a production method therefor.

### SUMMARY OF THE INVENTION

A semiconductor device according to the present invention is a semiconductor device comprising an IC chip and a coil connected to the IC chip, in which information transmission is performed by using as a transmission medium an induction field generated from the coil, and is characterized in that the coil and connecting terminals connected to the coil and electrically connected to the IC chip are formed of the same metal plate which is patterned.

In addition, a semiconductor device according to the present invention is characterized in that the above-described IC chip, coil, and connecting terminals are integrated by being encapsulated with a resin.

A semiconductor device according to the present invention is a semiconductor device comprising an IC chip and a coil connected to the IC chip, in which information transmission is performed by using as a transmission medium an induction field generated from the coil, and is characterized in that an IC chip supporting section where the IC chip is mounted, the coil, and the connecting terminals connected to the coil and electrically connected to the IC chip are formed of the same metal plate which is patterned.

In addition, a semiconductor device according to the present invention is characterized in that the above-described IC chip, IC chip supporting section, coil, and connecting terminals are integrated by being encapsulated with a resin.

Furthermore, a semiconductor device according to the present invention is characterized in that at least one side of the above-described coil is exposed from a surface of the above-described resin.

Moreover, a semiconductor device according to the present invention is characterized in that the above-described IC chip and the above-described connecting terminals are connected with jumpers, and the jumpers are also encapsulated with the above-described resin.

In addition, a semiconductor device according to the present invention is characterized in that the above-described IC chip and the above-described connecting terminals are connected in flip chip connection.

Furthermore, a semiconductor device according to the present invention is characterized in that a part of one side of the above-described coil is bonded and fixed with a tape.

A method of producing a semiconductor device according to the present invention is characterized by comprising: a step of forming a metal frame having at least a coil pattern for forming a coil for generating an induction field, and a connecting terminal pattern for electrical connection to the above-described IC chip by connection to the above-described coil pattern, from the same metal plate; a step of electrically connecting the connecting terminal pattern and the IC chip; and a step of encapsulating the IC chip and the metal frame with a resin.

A method of producing a semiconductor device according to the present invention is characterized by comprising: a step of forming a metal frame having at least an IC chip supporting section pattern for supporting an IC chip, a coil pattern for forming a coil for generating an induction field, and a connecting terminal pattern for electrical connection to the above-described IC chip by connection to the above-described coil pattern, from the same metal plate; a step of mounting the IC chip on the IC chip supporting section and electrically connecting the connecting terminal pattern and the mounted IC chip; and a step of encapsulating the IC chip and the metal frame with a resin.

In addition, a method of producing a semiconductor device according to the present invention is characterized in that the above-described metal frame is patterned by stamping or etching.

In addition, a method of producing a semiconductor device according to the present invention is characterized by further comprising a step of sticking a tape for fixing a coil pattern on a part of one side of the above-described coil pattern.

A method of producing a semiconductor device according to the present invention is characterized in that tying sections tying respective portions of the above-described coil pattern are formed in the above-described metal frame, and that the tying sections are cut after sticking the above-described tape.

A method of producing a semiconductor device according to the present invention is characterized in that the above-described IC chip and the above-described connecting terminal pattern are electrically connected by wire bonding, and that jumpers formed by bonding are also encapsulated with the above-described resin.

A method of producing a semiconductor device according to the present invention is characterized in that the above-described IC chip and the above-described connecting terminal pattern are electrically connected in flip chip connection.

In addition, an electrophotographic apparatus according to the present invention is characterized by including a process cartridge where the above-described semiconductor device is stuck.

### BRIEF DESCRIPTION OF THE DRAWINGS

FIG. 1 is a transparent perspective view showing the configuration of a non-contact type IC tag according to a first embodiment of the present invention;
FIG. 2 is a sectional view showing a resin encapsulation state;
FIG. 3 is a sectional view showing another resin encapsulation state;
FIG. 4 is a plan showing an iron-nickel frame where a coil pattern section, an IC chip supporting section, and a connecting pad are constituted;
FIGS. 5A, 5B, 5C and 5D are sectional views showing the production steps of an IC chip used for an IC tag;
FIGS. 6A, 6B, 6C and 6D are plan views showing the production steps of a frame for an IC tag,
FIG. 6E is an enlarged view of a portion 6E in FIG. 6A, and FIG. 6F is an enlarged view of a portion 6F in FIG. 6D;
FIG. 7 is a flow chart showing the production steps of the non-contact type IC tag according to the first embodiment of the present invention;
FIG. 8 is a sectional view showing an encapsulating method using an encapsulating resin material;
FIG. 9 is a sectional view showing another encapsulating method using an encapsulating resin material;
FIG. 10 is a plan showing a multi-chip frame for non-contact type IC tags;
FIG. 11 is a plan showing the configuration of a non-contact type IC tag according to a second embodiment of the present invention;
FIG. 12 is a sectional view showing a resin encapsulation state;
FIG. 13 is a plan showing an iron-nickel frame where a coil pattern section, and a connecting pad are constituted;
FIG. 14 is a perspective view showing the configuration of a non-contact type IC tag according to another embodiment of the present invention;
FIG. 15 is a plan view showing the configuration of a non-contact type IC tag according to still another embodiment of the present invention;
FIG. 16 is a perspective view showing an image formation apparatus having a process cartridge using an IC tag according to the present invention; and
FIG. 17 is a perspective view showing the process cartridge using the IC tag according to the present invention.

### DESCRIPTION OF THE PREFERRED EMBODIMENTS

Hereafter, embodiments of the present invention will be described in detail using drawings.

### (Embodiment 1)

This embodiment relates to a non-contact type IC tag having an IC chip and a coil connected to the IC chip, wherein the IC chip is mounted on an IC chip supporting section, wherein the IC chip and the coil are connected by wire bonding that uses a gold or aluminum wire, and wherein resin encapsulation is performed.

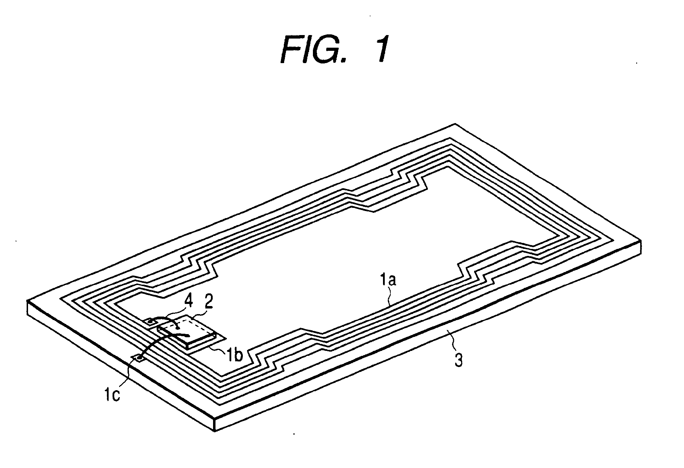

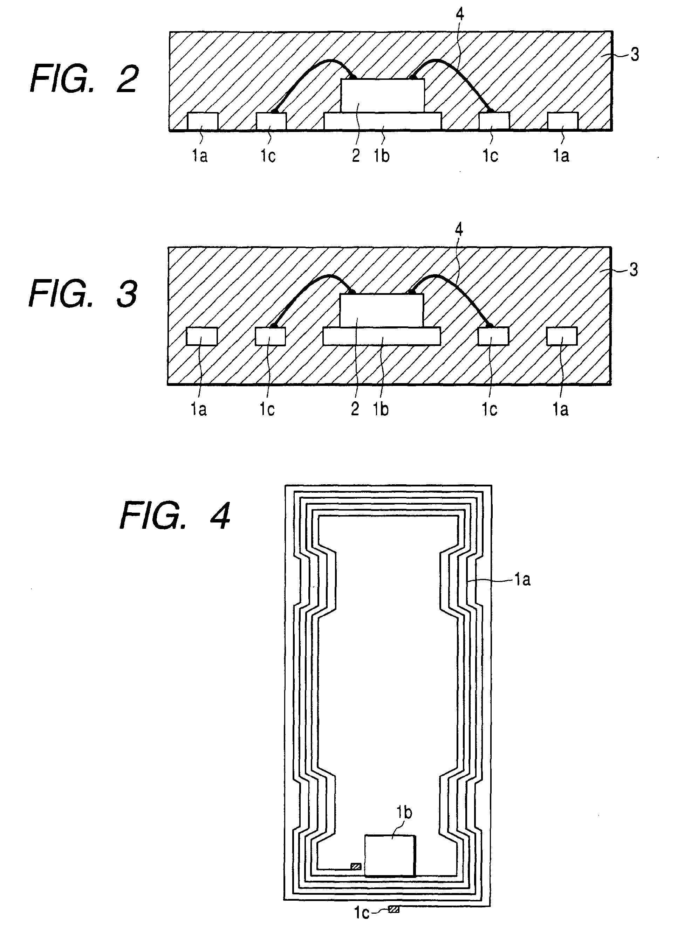

FIG. 1 is a transparent perspective view showing the configuration of a non-contact type IC tag according to this embodiment, and FIG. 2 is a schematic sectional view thereof. In FIGS. 1 and 2, reference character 1a denotes a coil pattern section formed by winding a strip pattern multiple times in the shape of a coil. The coil pattern section 1a becomes a coil for an antenna that is used in the IC tag of the present invention performing information transmission by using external parts and an electromagnetic wave as a transmission medium. An IC chip 2 performs the recording and processing of data transmitted and received by the coil pattern section 1a. The IC chip 2 is mounted on an IC chip supporting section 1b. Connecting terminal 1c is provided at the end of the coil pattern section 1a, and is connected to the IC chip 2. The coil pattern section 1a, IC chip supporting section 1b, and connecting terminals 1c are formed in one piece by performing patterning by etching or pressing (stamping) the same iron-nickel plate. FIG. 4 is a plan showing only the coil pattern section la, IC chip supporting section 1b, and mounting pad 1c that are produced by patterning.

The IC chip 2 is mounted (die-bonded) on the IC chip supporting section 1b, and connecting terminals of the IC chip 2 (not shown) are electrically connected to the connecting terminals 1c provided in both ends of the coil pattern section 1a with gold or aluminum wires 4 by wire bonding. An encapsulating resin material 3 encapsulates the coil pattern section 1a, IC chip supporting section 1b, connecting terminals 1c, IC chip 2, and wires 4. The encapsulating resin material 3 fixes the coil pattern section 1a, IC chip supporting section 1b, connecting terminals 1c, IC chip 2, and wires 4 to integrate them into a plate-like IC tag.

As seen from FIG. 2, the encapsulating resin material 3 encapsulates the IC chip 2 and wires 4 fully, and encapsulates the coil pattern section 1a, IC chip supporting section 1b, and connecting terminals 1c so that each one side of them may be exposed from the encapsulating resin material 3. It becomes possible to enhance the reliability of transmission and reception of an electromagnetic wave used as a transmission medium by exposing each one side. In addition, in production process, when the encapsulating resin material 3 encapsulates the coil pattern section 1a, IC chip supporting section 1b, connecting terminals 1c, IC chip 2, and wires 4, it is possible to support the coil pattern section 1a, IC chip supporting section 1b, connecting terminals 1c, IC chip 2, and wires 4 in a molding die. Hence, it is possible to resolve complicatedness on production.

Further, as shown in FIG. 3, the encapsulating resin material 3 may also fully encapsulate the coil pattern section 1a, IC chip supporting section 1b, and connecting terminals 1c in addition to the IC chip 2 and wires 4. It is possible to more securely fix the coil pattern section 1a, IC chip supporting section 1b, and connecting terminals 1c by fully encapsulating them. In addition, owing to this, environment resistance at the time of using it as an IC tag is enhanced and it can normally operate while being hardly influenced by a change of temperature, humidity, or the like, whereby the reliability of operation as the IC tag is enhanced.

Whether one side of each of the coil pattern section 1a, IC chip supporting section 1b, and connecting terminals 1c is exposed or whole surfaces thereof is encapsulated can be just selected optionally according to a purpose of use, an operating environment, etc.

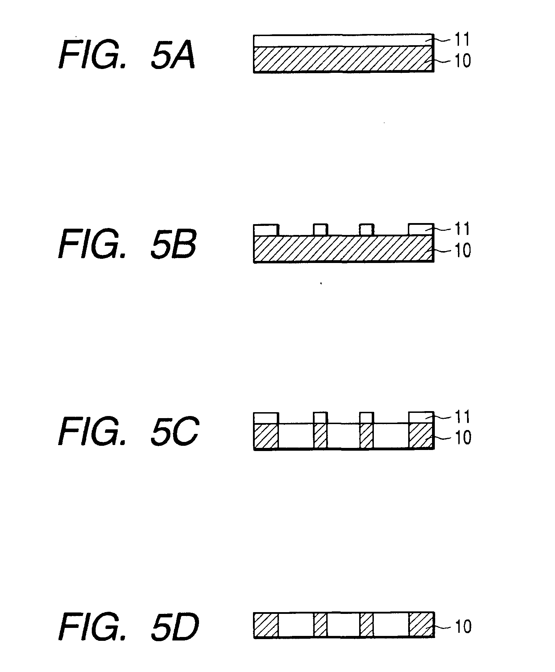

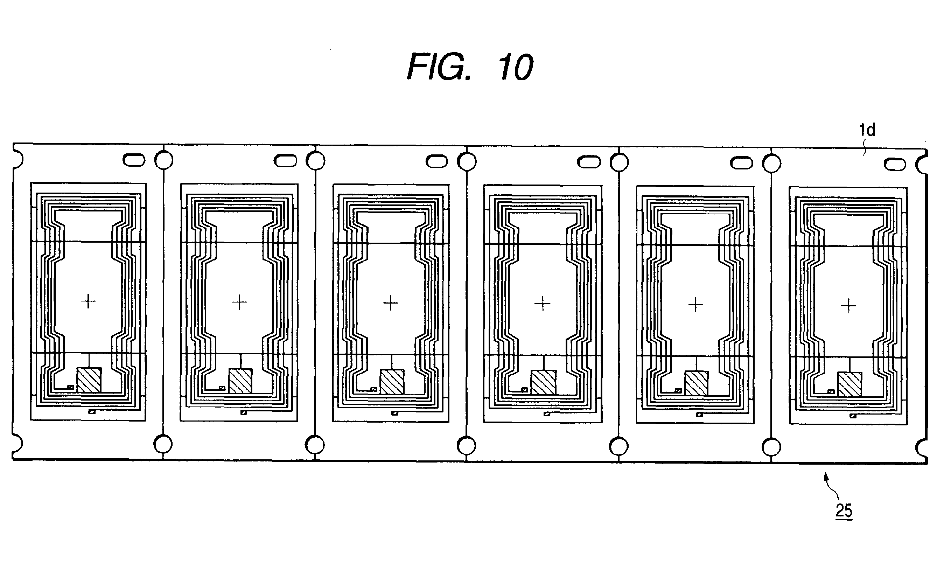

Next, the steps of a method of producing the above-described non-contact type IC tag will be described referring to FIGS. 5A to 5D and FIG. 10.

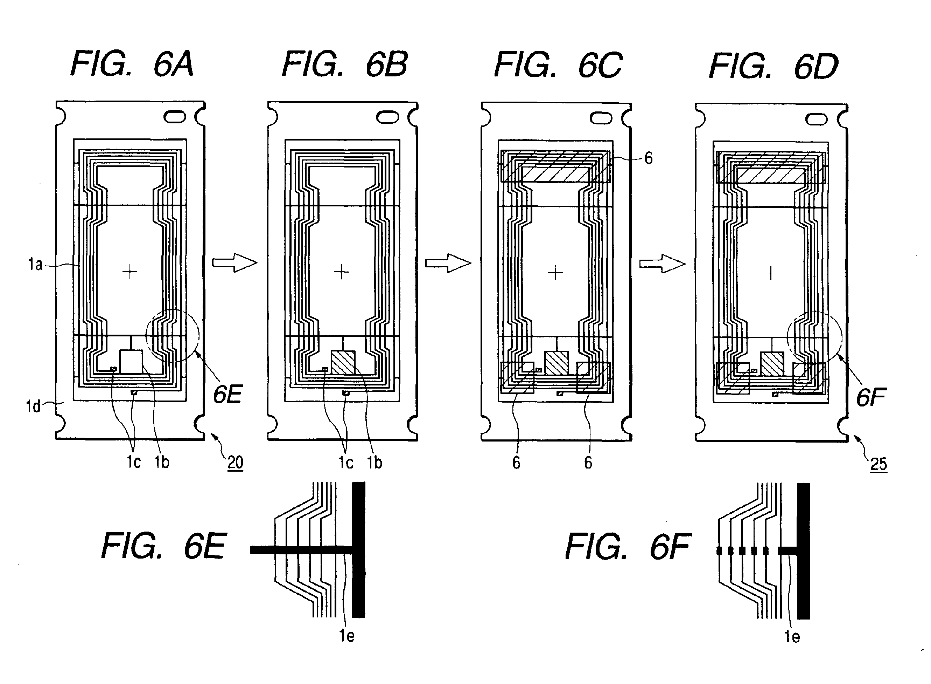

FIGS. 5A to 5D and FIGS. 6A to 6F are sectional views and plan views for explaining the production steps of a frame for the IC tag which consists of the coil pattern section 1a, IC chip supporting section 1b, connecting terminals 1c, and an outer frame section 1d which supports them.

First, steps of patterning a frame pattern consisting of the coil pattern section 1a, IC chip supporting section 1b, connecting terminals 1c, and outer frame section thereof 1d in an iron-nickel plate 10 will be described with reference to FIGS. 5A to 5D.

First of all, in FIG. 5A, a photosensitive material 11 consisting of a liquid resist or a dry film resist is applied on an iron-nickel plate 10 (a single plate or a hoop) having a size of 43 mm in width, 200 mm in length and 0.4 mm in thickness.

Next, in FIG. 5B, a pattern of the coil pattern 1a, and the IC chip supporting section 1b, a pattern of the connecting terminals 1c, and a pattern of the outer frame section 1d are printed on the metal plate 10, on which the photosensitive material 11 is applied, by using a mask not shown, and are developed by using a chemical developer consisting of sodium carbonate, meta-silicic acid, a solvent, etc.

Next, in FIG. 5C, etching is performed up to the back face of the iron-nickel plate 10 by using etchant such as copper chloride and ferric chloride.

Subsequently, in FIG. 5D, the photosensitive material 11 used as the resist of etching is peeled by using alkali peel liquid such as sodium hydroxide, caustic potash, and a solvent. Thereby, the frame pattern consisting of the coil pattern section 1a, IC chip supporting section 1b, connecting terminals 1c, and their outer frame section 1d are patterned in the iron-nickel plate 10.

In addition, as for the step of patterning the frame pattern, it is also possible to perform the patterning by stamping instead of the above-described etching. In case of forming the frame pattern by stamping, the patterning is performed by stamping an iron-nickel plate with a stamping die having the frame pattern consisting of the coil pattern section 1a, IC chip supporting section 1b, connecting terminals 1c, and their outer frame section 1d.

FIG. 6A shows an iron-nickel plate 20 patterned according to FIGS. 5A to 5D. The patterned iron-nickel plate 20 shown in FIG. 6A connects respective portions of the coil pattern section 1a with a tying sections 1e shown in FIG. 6E so that the coil pattern section 1a should be deformed in the shape of a spring in the direction perpendicular to the patterned iron-nickel plate 20. In addition, the tying sections partially connect the outermost periphery of the coil pattern section 1a to the outer frame section 1d. In addition, the tying sections 1e also connects to the IC chip supporting section 1b to prevent its deformation.

Next, as shown in FIG. 6B, the IC chip supporting section 1b and connecting terminals 1c are plated with silver or gold. Furthermore, as shown in FIG. 6C, sheets of tape 6 are partially stuck on one side of the coil pattern section 1a in the patterned iron-nickel plate 20. The sheets of tape 6 each have the size of not disturbing a function of the coil pattern section 1a as an antenna, and fix the coil pattern section 1a. The sheets of tape 6 further strengthen the prevention of deformation of the coil pattern section 1a by the tying sections 1e, and the patterned iron-nickel plate 20 never deforms even if being transferred to the next step.

Next, as shown in FIG. 6D, tying portions, tying respective portions of the coil pattern section 1a, and tying portions with the IC chip supporting section 1b in the tying sections 1e are cut with a cutter or a press, which is not shown, as shown in FIG. 6F. At this time, tying portions connecting the outermost periphery of the coil pattern section 1a in the tying sections 1e to the outer frame section id are not cut. Even if the tying portions connecting respective portions of the coil pattern section 1a in the tying sections 1e, and the tying portions with the IC chip supporting section 1b are cut, the coil pattern section 1a is never deformed since being fixed by the sheets of tape 6.

In addition, the tying portions connecting respective portions of the coil pattern section 1a in the tying sections 1e, and the tying portions with the IC chip supporting section 1b are not always indispensable. If the coil pattern section 1a and IC chip supporting section 1b have high rigidity, they have sufficient rigidity without the tying sections 1e, and are not deformed, whereby the above-described typing sections are not necessary. In this case, the taping step shown in FIG. 6C and the cutting step of the tying sections 1e that is shown in FIG. 6D are unnecessary.

Thus, a frame 25 for an IC tag is produced using the steps shown in FIGS. 5A to 5D and 6A to 6F.

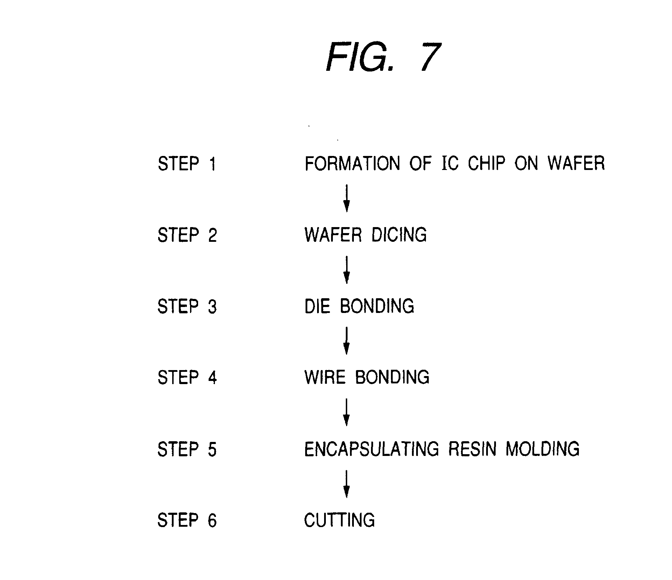

Next, by using FIG. 7, the production process of an IC tag using the frame 25 for an IC tag produced through the steps shown in FIGS. 5A to 5D and FIGS. 6A to 6F will be described.

First, at STEP 1, a plurality of IC chips is formed by oxidizing a 5 to 8 inch Si wafer and performing steps such as photo-etching. The thickness of the plurality of IC chips is adjusted by performing wafer back grinding if needed. Wafer back grinding makes it possible to thin the IC tag, to lighten the IC tag, and to reduce the cost of the encapsulating resin material 3.

Next, at STEP 2, the IC chips 2 are produced by dividing (wafer-dicing) the plurality of IC chips formed on the Si wafer at STEP 1.

Subsequently, at STEP 3, the IC chip 2 produced at STEP 2 is bonded and fixed (die-bonded) on the IC chip supporting section 1b of the frame 25 for an IC tag produced at the step shown in FIGS. 6A to 6F.

Next, at STEP 4, the IC chip 2 and connecting terminals 1c of the frame 25 for an IC tag are electrically connected with gold or aluminum wires 4 by wire bonding.

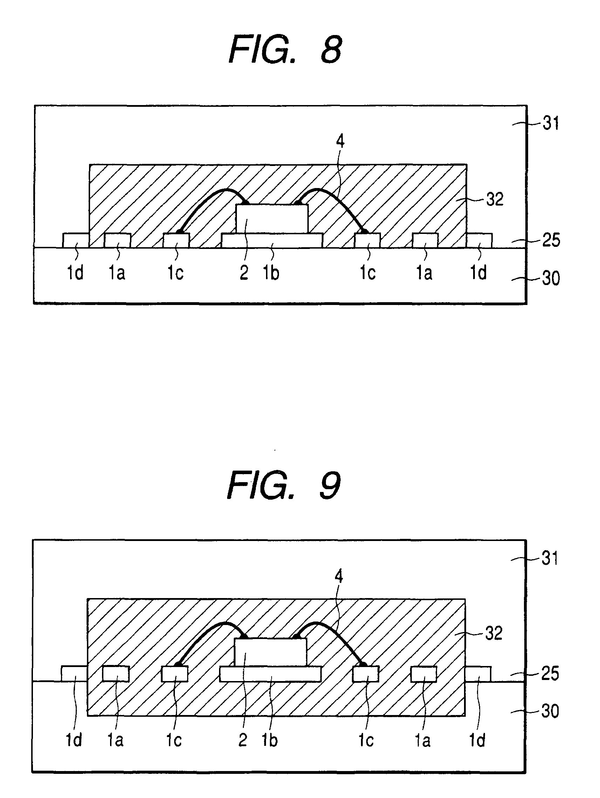

Next, at STEP 5, a method of encapsulating the IC chip 2 and the frame 25 for an IC tag by the encapsulating resin material 3 will be described with reference to FIG. 8. In FIG. 8, reference numeral 30 denotes a fixed die and reference numeral 31 denotes a movable die. First, the frame 25 for an IC tag is held on the fixed die 30. At this time, the outer frame section 1d of the frame 25 for an IC tag is arranged so that the outer frame section 1d may be located in the outside of a mold cavity 32, into which the encapsulating resin material 3 is injected, and that the outer frame section 1d is not encapsulated with the encapsulating resin material 3. Next, the fixed die 30 and movable die 31 are opened after injecting the encapsulating resin material 3 into the mold cavity 32 and curing the encapsulating resin material 3, and the frame 25 for an IC tag covered with the encapsulating resin material 3 is taken out.

It is possible to expose each one side of the coil pattern section 1a, IC chip supporting section 1b, and connecting terminals 1c from the encapsulating resin material 3 as shown in FIG. 2 by holding the frame 25 for an IC tag on the fixed die 30 as shown in FIG. 8.

In addition, it is also possible to thoroughly encapsulate the coil pattern section 1a, IC chip supporting section 1b, and connecting terminals 1c besides the IC chip 2 and wires 4 as shown in FIG. 3 by holding the frame 25 for an IC tag in the state of floating the frame 25 for an IC tag in the mold cavity 32 within the fixed die 30 and movable die 31 as shown in FIG. 9.

Next, at STEP 6 in FIG. 7, the IC tag is completed by cutting the tying portions 1e, which tie the outermost periphery of the coil pattern section 1a with the outer frame section 1d and are not cut at the step shown in FIG. 6D, and separating the outer frame section 1d from the IC tag.

The IC tag is produced by passing through the above steps.

In addition, as shown in FIG. 10, a plurality of IC tags according to this embodiment may be produced simultaneously from the same metal frame. In this case, the IC tags can be separated from the outer frame sections 1d of the frame 20 for IC tags simultaneously, or can be cut in order.

In addition, although an iron-nickel plate is used as a metal frame in this embodiment, another material, for example, a copper plate can be also used.

### (Embodiment 2)

This embodiment relates to a non-contact type IC tag that has an IC chip and a coil connected to the IC chip, and is encapsulated with a resin after the electrical connection of the IC chip and coil in flip chip connection.

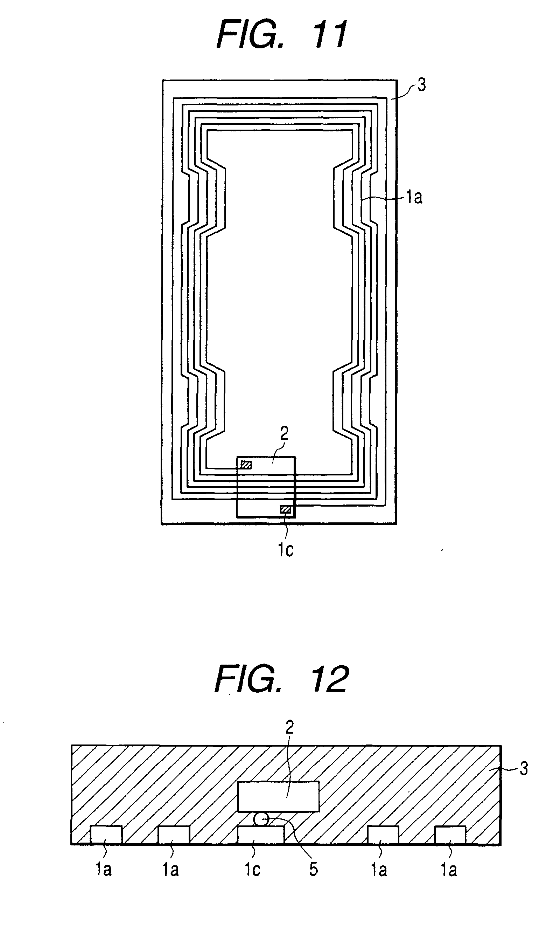

FIG. 11 is a plan showing the configuration of a non-contact type IC tag according to this embodiment, and FIG. 12 is a sectional view thereof. In Embodiment 2, the same reference characters are assigned to the same members as those in Embodiment 1.

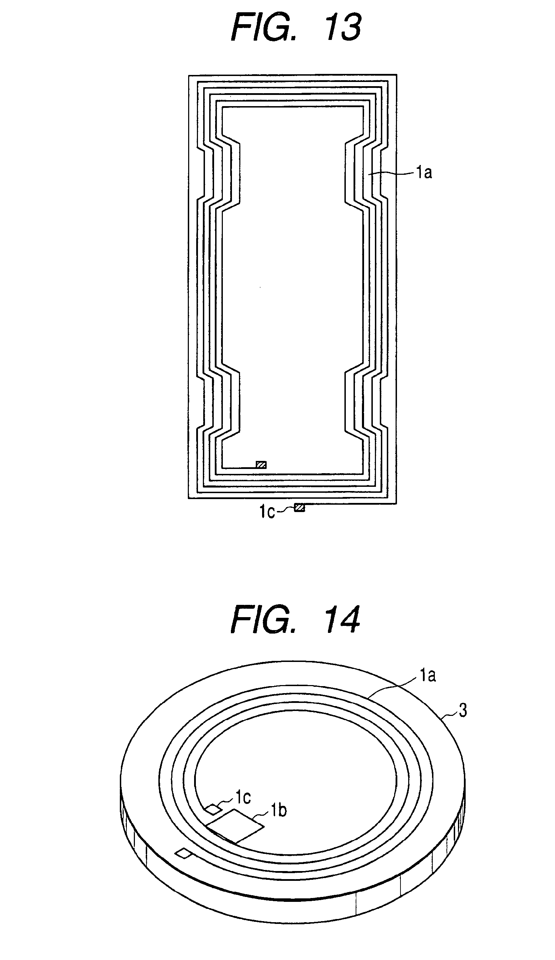

In FIGS. 11 and 12, reference character 1a denotes a coil pattern section formed by winding a strip multiple times in the shape of a coil. The coil pattern section 1a becomes a coil for an antenna that is used in this IC tag performing information transmission by using external parts and an electromagnetic wave as a transmission medium. An IC chip 2 performs the recording and processing of data transmitted and received by the coil pattern section 1a. Connecting terminal 1c is provided at the end of the coil pattern section 1a, and is connected to the IC chip 2. The coil pattern section 1a and connecting terminals 1c are made by performing patterning by etching or pressing (stamping) the same iron-nickel plate. FIG. 13 is a plan showing only the coil pattern section 1a and connecting terminals 1c that are produced by patterning.

Above the coil pattern section 1a, the IC chip 2 is electrically connected with connecting terminals 1c in flip chip connection through bumps 5 such as Au bumps or solder bumps. An encapsulating resin material 3 encapsulates the coil pattern section 1a, IC chip supporting section 1b, connecting terminals 1c, IC chip 2, and wires 4. In addition, a connection material other than a metal bump, such as an anisotropy electroconductive film may be also used as each of the bumps 5.

In addition, although the coil pattern section 1a, connecting terminal 1c, and IC chip 2 are encapsulated so that each one side of an iron-nickel frame may be exposed from an encapsulating resin material 3 as shown in FIG. 12, similarly to Embodiment 1, the coil pattern section 1a, connecting terminal 1c, and IC chip 2 may be thoroughly encapsulated with the resin material.

For an IC tag according to this embodiment, it is possible to use a production method that is the almost same as that in Embodiment 1 described by using FIGS. 5A through 10. The difference from Embodiment 1 is the point of electrically connecting the IC chip 2 to the connecting terminal 1c in flip chip connection by using the bumps 5 instead of the die bonding step shown in STEP 3 and the wire bonding step shown in STEP 4 in FIG. 7.

It is possible to omit comparatively complicated steps such as a die bonding step and a wire-bonding step, and hence, to sharply reduce the production cost by performing the flip chip connection. In addition, since it is not necessary to form the IC chip supporting section 1b, it is possible to plan the weight reduction of an IC tag. Furthermore, since the IC chip 2 can be arranged above the coil pattern section 1a, a design space of the coil pattern section 1a becomes large, and hence, it is possible to plan the upgrade of functions as an IC tag.

In addition, although an iron-nickel plate is used as a metal frame in this embodiment, another material, for example, a copper plate can be also used.

### (Other embodiments)

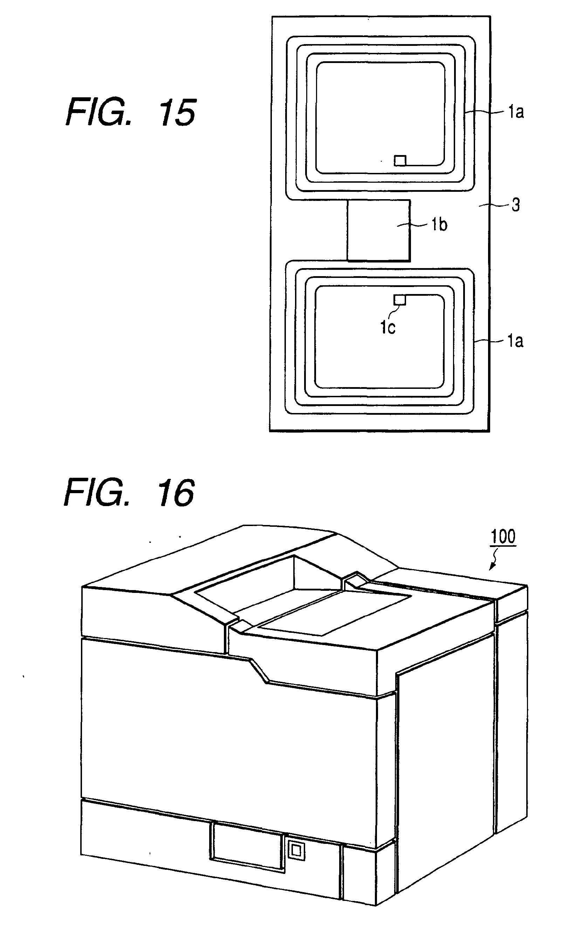

In the embodiments described above, although the IC tag with rectangular geometry is used and described as the examples as shown in FIGS. 1 and 11, geometry is not especially limited, and hence, for example, as shown in FIG. 14, round geometry can be used. In addition, as shown in FIG. 15, a coil pattern section may be divided into two portions and arrange them, and to arrange an IC chip in a center section.

A semiconductor device according to the present invention can use as a non-contacting type IC card, an IC tag, or the like where an IC chip including a microprocessor and semiconductor memory such as RAM and ROM, and a coil for functioning as an electric power supply and a communication antenna are mounted. Also, a battery for applying a voltage to the IC chip may be provided, if necessary.

The IC tag performs information transmission via an induction field in a comparatively short distance, and hence, is used for an application requiring a medium smaller and lighter than an IC card. For example, the non-contacting type IC card can be used for the payment of a ticket fare, bank dealings, identification, and record of information such as a clinical history. In addition, the non-contacting type IC tag can be used for the recording of process management information such as a lot number of a product, and the recording of operating conditions such as a usage count after product sale, and of use restriction information, etc.

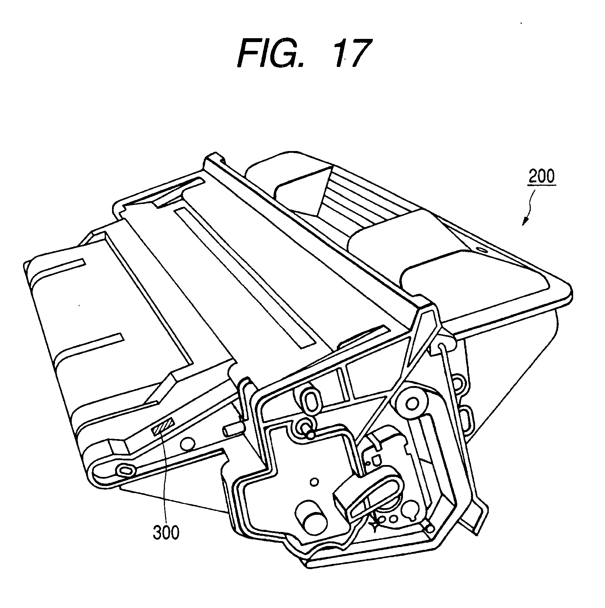

An example where the IC tag according to the present invention is applied to a process cartridge used for an image formation apparatus will be described with referring to FIGS. 16 and 17.

FIG. 16 is a perspective view of an image formation apparatus 100 where a process cartridge is used. An electrophotography copying machine, an electrophotographic printer, etc. are included as examples of the image formation apparatus. FIG. 17 is a perspective view of a process cartridge 200 used for the image formation apparatus 100 shown in FIG. 16. The process cartridge is a cartridge that is made by integrating charging means, developing means or cleaning means, and an electrophotographic photosensitive member, and is detachable from a body of the image formation apparatus. In addition, the process cartridge is a cartridge that is made by integrating at least one of charging means, developing means, and cleaning means, and an electrophotographic photosensitive member, and is detachable from a body of the image formation apparatus. Furthermore, the process cartridge is a cartridge that is made by integrating at least one of developing means, and an electrophotographic photosensitive member, and is detachable from a body of the image formation apparatus. In FIG. 17, reference numeral 300 denotes the IC tag stuck on the process cartridge 200.

The process cartridge 200 that contains toner is an interchangeable unit that needs to be exchanged at the time of exhaustion of the toner. Such an interchangeable unit is exchanged by performing residual quantity detection of toner etc. and reporting exchange time to a user.

However, if a process cartridge used in an image formation apparatus is loaded in another image formation apparatus, it is difficult to determine how much the process cartridge was used. In addition, as for the residual quantity detection of toner, since a user can prepare an exchange unit, reporting to the user before the toner is exhausted and printing becomes impossible is desirable rather than reporting of the toner being exhausted.

Further ideally, if the amount of a consumable is always reported, a user can exactly grasp a use state of the consumable as well as exchange time, and hence, for example, when the user is going to print many documents, it becomes information for determining whether the consumable is fully new. Thus, as for an interchangeable unit, it is desirable that a use state can be exactly grasped.

When the process cartridge 200 is loaded into the image formation apparatus 100, a transmitter-receiver that is not shown and is provided in the image formation apparatus 100 reads use restriction information such as time that corresponds to the amount of the toner and is stored beforehand in the IC tag 300. In addition, after use, the above-described transmitter-receiver provided in the image formation apparatus 100 writes use information such as actually used time in the IC tag 300. Thus, it is possible to exactly grasp the use state by the information transmission from the IC tag 300 and above-described transmitter-receiver provided in the image formation apparatus 100.

As described above, according to the present invention, it is not necessary to use a substrate used up to now by forming a semiconductor device such as an IC tag and an IC card by encapsulating an IC chip supporting section, a coil for an antenna and connecting terminals which are patterned and formed by stamping or etching of the same metal plate, as well as an IC chip mounted on the IC chip supporting section, with an encapsulating resin material. Hence, since it is possible to reduce the number of parts, it is possible to reduce material cost. In addition, since it is possible to perform thinning and weight reduction, it is easily possible to incorporate the semiconductor device in another product or to stick it to another product. Furthermore, it is possible to simplify the production steps by adopting the above-described configuration, and hence, it is also possible to reduce the production cost.

Moreover, according to the present invention, it is not necessary to form an IC chip supporting section by forming a semiconductor device such as an IC tag and an IC card by encapsulating a coil for an antenna and connecting terminals which are patterned and formed by stamping or etching of the same metal plate, as well as an IC chip mounted in flip chip connection, with an encapsulating resin material. Hence, it is possible to further reduce its weight. In addition, since a space where a coil is formed becomes large, it is possible to upgrade functions as an antenna. Furthermore, it is possible to further simplify the production steps by adopting the above-described configuration.

Moreover, it becomes possible to surely perform the transmission and reception of an electromagnetic wave used as a transmission medium by forming a coil pattern section, an IC chip supporting section, and connecting terminals so that one side of each of them may be exposed from a surface of an encapsulating resin material. In the case of performing encapsulation with an encapsulating resin material, it is easy to support these sections and terminals, and hence, it is possible to resolve the complicatedness on production.

In addition, by fully encapsulating a coil pattern section, an IC chip supporting section, and also connecting terminals with the encapsulating resin material 3, it becomes possible to further surely fix the coil pattern section, IC chip supporting section, and connecting terminals. Furthermore, since the environment resistance at the time of using it as a semiconductor device is improved, reliability of the device is improved.

Moreover, according to the present invention, when the patterning of a frame pattern consisting of a coil pattern section, an IC chip supporting section, connecting terminals, and its outer frame section is performed in the same metal plate, tying sections tying respective portions of the coil pattern section, tying the outermost periphery of the coil pattern section with the outer frame sections 1d, and tying the coil pattern section with the IC chip supporting section 1b are formed. This prevents that the coil pattern section deforms during production. In addition, on one side of the coil pattern section, pieces of tape are stuck partially. Owing to this, the deformation of the coil pattern section is further suppressed, and, even when the tying portions between portions of the coil pattern section and tying portions between the coil pattern section and the IC chip supporting section 1b are cut, the coil pattern section does not deform.

Furthermore, according to the present invention, it is possible to further thin a semiconductor device by mounting an IC chip, produced by using wafer back grinding, on the semiconductor device such as an IC tag or an IC card.

Moreover, a semiconductor device produced according to the present invention can be mounted in a process cartridge of an electrophotographic apparatus without considering a space.

The semiconductor device of the present invention comprises an IC chip, and a coil connected to the IC chip, in which information is transmitted by using as a transmission medium an induction field generated from the coil, characterized in that the coil, and connecting terminals connected to the coil and electrically connected to the IC chip are formed of the same metal plate that is patterned.

## Claims

1. A semiconductor device comprising an IC chip, and a coil connected to the IC chip, in which information is transmitted by using as a transmission medium an induction field generated from the coil,
**characterized in that** the coil, and connecting terminals connected to the coil and electrically connected to the IC chip are formed of the same metal plate that is patterned.

2. The semiconductor device according to claim 1, **characterized in that** the IC chip, the coil, and the connecting terminals are encapsulated with a resin to be integrated with one another.

3. The semiconductor device comprising an IC chip, and a coil connected to the IC chip, in which information is transmitted by using as a transmission medium an induction field generated from the coil,
**characterized in that** an IC chip supporting section where the IC chip is mounted, the coil, and connecting terminals connected to the coil and electrically connected to the IC chip are formed of the same metal plate that is patterned.

4. The semiconductor device according to claim 3, **characterized in that** the IC chip, the IC chip supporting section, the coil, and the connecting terminals are encapsulated with a resin to be integrated with one another.

5. The semiconductor device according to claims 2 or 4, **characterized in that** at least one side of the coil is exposed from a surface of the resin.

6. The semiconductor device according to claims 2 or 4, **characterized in that** the IC chip and the connecting terminals are connected by wires, and the wires are encapsulated with the resin.

7. The semiconductor device according to claims 2 or 4, **characterized in that** the IC chip and the connecting terminals are connected in flip chip connection.

8. The semiconductor device according to claims 2 or 4, **characterized in that** a part of one side of the coil is bonded and fixed with a tape.

9. A method of producing a semiconductor device that transmits information by using as a transmission medium an induction field generated from a coil electrically connected to an IC chip, **characterized by** comprising the steps of:
forming a metal frame having at least a coil pattern for forming a coil for generating the induction field, and a connecting terminal pattern for connection to the coil pattern and electrical connection to the IC chip, from the same metal plate;
mounting the IC chip on the metal frame;
electrically connecting the connecting terminal pattern to the IC chip; and
encapsulating the IC chip and the metal frame with a resin.

10. A method of producing a semiconductor device that transmits information by using as a transmission medium an induction field generated from a coil electrically connected to an IC chip, **characterized by** comprising the steps of:
forming a metal frame having at least an IC chip supporting section pattern for supporting the IC chip, a coil pattern for forming a coil for generating the induction field, and a connecting terminal pattern for connection to the coil pattern and electrical connection to the IC chip, from the same metal plate;
mounting the IC chip on the IC chip supporting section and electrically connecting the connecting terminal pattern to the IC chip that is mounted; and
encapsulating the IC chip and the metal frame with a resin.

11. The method of producing a semiconductor device according to claims 9 or 10, **characterized in that** patterning of the metal plate is performed by stamping or etching.

12. The method of producing a semiconductor device according to claims 9 or 10, **characterized in that** electrical connection of the connecting terminal pattern and the IC chip is performed by wire bonding, and that wires formed by the wire bonding are encapsulated with the resin.

13. The method of producing a semiconductor device according to claim 9, **characterized in that** electrical connection of the connecting terminal pattern and the IC chip is performed in flip chip connection.

14. The method of producing a semiconductor device according to claims 9 or 10, **characterized by** further comprising a step of sticking a tape for coil pattern fixation on a part of one side of the coil pattern after the connecting terminal pattern and the IC chip are electrically connected.

15. A method of producing a semiconductor device that transmits information by using as a transmission medium an induction field generated from a coil electrically connected to an IC chip, **characterized by** comprising the steps of:
preparing one sheet of metal plate;
forming a metal frame having at least a coil pattern, a connecting terminal pattern formed at an end of the coil pattern, and a tying section tying respective portions of the coil pattern, by patterning the metal plate;
mounting the IC chip on the metal frame;
electrically connecting the connecting terminal pattern to the IC chip;
sticking a tape for coil pattern fixation on a part of one side of the coil pattern;
cutting the tying section; and
encapsulating the IC chip and the metal frame with a resin to integrate them.

16. A method of producing a semiconductor device that transmits information by using as a transmission medium an induction field generated from a coil electrically connected to an IC chip, **characterized by** comprising the steps of:
preparing one sheet of metal plate;
forming a metal frame having at least a coil pattern, a connecting terminal pattern formed at an end of the coil pattern, an outer frame section, and a tying section tying respective portions of the coil pattern and tying the coil pattern and the outer frame section, by patterning the metal plate;
mounting the IC chip on the metal frame;
electrically connecting the connecting terminal pattern to the IC chip;
sticking a tape for coil pattern fixation on a part of one side of the coil pattern after the connecting terminal pattern and the IC chip are electrically connected;
cutting the tying section tying respective portions of the coil pattern;
encapsulating the IC chip and the metal frame with a resin to integrate them; and
cutting the tying section tying the coil pattern and the outer frame section.

17. The method of producing a semiconductor device according to claim 16, **characterized in that** a plurality of semiconductor devices is produced from the one sheet of the metal plate.

18. An electrophotographic apparatus **characterized by** comprising:
a process cartridge on which the semiconductor device according to any one of claims 1 to 4 is stuck and which is detachably mounted on the electrophotographic apparatus; and
a transmission-reception unit for transmitting information to and receiving information from the semiconductor device.
